# EUROPÄISCHE PATENTSCHRIFT

(11) **EP 1 629 537 B1**
(45) Veröffentlichungstag und Bekanntmachung des Hinweises auf die Patenterteilung: **30.07.2014**
(21) Anmeldenummer: 04728512.7
(22) Anmeldetag: 21.04.2004
(51) Int. Cl.: H01L 33/58, H01L 33/48

(54) **LUMINESZENZDIODE**
LIGHT-EMITTING DIODE
DIODE ELECTROLUMINESCENTE

(30) Priorität: 30.05.2003 DE 10324608; 27.06.2003 DE 10329081
(43) Veröffentlichungstag der Anmeldung: 01.03.2006
(73) Patentinhaber: OSRAM Opto Semiconductors GmbH, 93055 Regensburg (DE)
(72) Erfinder: BOGNER, Georg, 93138 Lappersdorf (DE); BRAUNE, Bert, 93173 Wenzenbach (DE); SCHMID, Josef, 93083 Obertraubling (DE)
(74) Vertreter: Epping - Hermann - Fischer
(86) Internationale Anmeldenummer: PCT/DE2004/000829
(87) Internationale Veröffentlichungsnummer: WO 2004/109813

(56) Entgegenhaltungen:
- EP-A- 0 230 336
- EP-A- 0 933 823
- WO-A-02/091489
- WO-A-2004/023522
- DE-A1- 3 117 571
- DE-A1- 10 137 641
- US-A1- 2003 067 264
- PATENT ABSTRACTS OF JAPAN Bd. 1998, Nr. 14, 31. Dezember 1998 (1998-12-31) & JP 10 233532 A (HOUSHIN KAGAKU SANGIYOUSHIYO), 2. September 1998 (1998-09-02)
- PATENT ABSTRACTS OF JAPAN Bd. 008, Nr. 078 (E-237), 10. April 1984 (1984-04-10) & JP 58 225673 A (NIPPON DENKI KK), 27. Dezember 1983 (1983-12-27)

## Beschreibung

Die Erfindung betrifft eine Lumineszenzdiode mit einem in eine Vergußmasse eingebetteten, auf einem Trägerkörper befestigten strahlungsemittierenden Halbleiterchip und einem Linsenkörper.

Lumineszenzdioden werden typischerweise in Gehäuse eingebaut, an die vielfältige Anforderungen gestellt werden. Das Gehäuse soll eine ausreichende mechanische Stabilität gewährleisten, die Montage ermöglichen, die elektrischen Anschlüsse enthalten, eine gute Wärmeabfuhr gewährleisten, die LED vor Umwelteinflüssen schützen und eine hohe Leuchteffizienz, beispielsweise durch fokussierende oder reflektierende Elemente, gewährleisten.

Ein häufig verwendeter Typ eines LED-Gehäuses ist beispielsweise aus der Figur 10 der WO 97/50132 bekannt. Das Gehäuse enthält einen Kunststoff-Grundkörper, mit dem nach außen aus dem Gehäuse herausragende elektrische Leiterbahnen umspritzt sind. Der Halbleiterchip befindet sich in einer Ausnehmung des Gehäuses und ist mit seiner Unterseite mit einer Leiterbahn kontaktiert. Die Oberseite des Halbleiterchips ist über einen Drahtbond mit einer zweiten elektrischen Leiterbahn kontaktiert. Die dem Halbleiterchip zugewandten Innenflächen des Gehäuses sind so angeschrägt, daß sie die Strahlung des Halbleiterchips nach oben aus dem Gehäuse heraus reflektieren. Die Ausnehmung des Gehäuses mit dem Halbleiterchips ist mit einer Vergußmasse ausgefüllt, die einerseits den Halbleiterchip vor mechanischen Einwirkungen schützt und andererseits auch Konversionsstoffe enthalten kann, die zur Konversion der vom Halbleiterchip ausgesandten Strahlung zu höheren Wellenlängen hin dient.

Eine weitere Form eines LED-Gehäuses wird in der US 6,274,924 B1 offenbart. Auch dieses Gehäuse enthält einen Kunststoff-Grundkörper, der die elektrischen Leiterbahnen umschließt. Um eine verbesserte Wärmeabfuhr zu erreichen, wird die LED von einem als Wärmesenke dienendem Körper mit hoher thermischer Leitfähigkeit umschlossen. Dieser typischerweise aus Metall bestehende Körper kann einen zylinderförmigen Reflektor enthalten. Zur Strahlfokussierung ist vorgesehen, eine vorgefertigte Kunststofflinse auf das Gehäuse aufzusetzen oder die LED in eine als Linse ausgebildete Masse aus Epoxidharz zu vergießen.

US2003/0067264 A1 offenbart eine Lumineszenzdiode mit einem in eine Vergussmasse eingebetteten, auf einem Trägerkörper befestigten strahlungsemittierenden Halbleiterchip, und einem Linsenkörper, wobei der Trägerkörper aus einer Keramik besteht und der Linsenkörper aus einem Glas besteht, wobei der Linsenkörper eine der Vergussmasse zugewandte Aussparung aufweist.

Bei LEDs, die im Bereich des blauen und des ultravioletten Spektralbereich emittieren, besteht die Gefahr, daß sie durch ihre Strahlung das Gehäusematerial, welches in der Regel aus Kunststoffen besteht, schädigen. Dieses äußerst sich in einer Vergilbung oder Schwärzung des Materials. Außer den mechanischen und elektrischen Eigenschaften kann dadurch auch die Lichtauskopplung verschlechtert werden.

Der Erfindung liegt die Aufgabe zugrunde, eine Lumineszenzdiode anzugeben, die gegen Strahlung aus dem ultravioletten Spektralbereich vergleichsweise unempfindlich ist.

Diese Aufgabe wird erfindungsgemäß durch eine Lumineszenzdiode mit den Merkmalen des Patentanspruchs 1 gelöst. Vorteilhafte Ausgestaltungen und Weiterbildung der Erfindung sind Gegenstand der Unteransprüche.

Eine Lumineszenzdiode enthält gemäß der Erfindung einen in eine Vergußmasse eingebetteten, auf einem Trägerkörper befestigen strahlungsemittierenden Halbleiterchip, und einen Linsenkörper, wobei der Trägerkörper aus Silizium oder einer Keramik und der Linsenkörper aus einem Glas besteht.

Eine solche Lumineszenzdiode hat gegenüber Lumineszenzdioden, bei denen der Trägerkörper und/oder ein zur Fokussierung oder zur Verbesserung der Auskopplung der emittierten Strahlung dienender Linsenkörper aus einem Polymer besteht, den Vorteil, daß sie aufgrund der in der Erfindung verwendeten Materialien gegen Strahlung aus dem ultravioletten Spektralbereich vergleichsweise unempfindlich ist.

Eine Lumineszenzdiode mit einem derartigen Gehäuse ist insbesondere für strahlungsemittierende Halbleiterchips geeignet, die Strahlung im Bereich des blauen und des ultravioletten Spektralbereichs emittieren. Dies betrifft besonders bei Wellenlängen kleiner als 460 nm und vor allem bei Wellenlängen kleiner als 430 nm emittierende Lumineszenzdioden. Insbesondere von blauen Leuchtdioden ist bekannt, daß diese auch kurzwellige Strahlungsanteile bis hinein in den ultraviolletten Strahlungsbereich emittieren.

Der strahlungsemittierende Halbleiterchip kann insbesondere einen Nitridverbindungshalbleiter enthalten, wobei unter einem Nitridverbindungshalbleiter eine Nitridverbindung von Elementen der dritten und/oder fünften Hauptgruppe des Periodensystems, insbesondere GaN, AlGaN, InGaN, AlInGaN, AIN oder InN, verstanden wird.

Der Trägerkörper besteht vorzugsweise aus einer Keramik, die insbesondere Aluminiumnitrid oder Aluminiumoxid enthalten kann. Weiter bevorzugt ist der Trägerkörper mit Leiterbahnen zur Kontaktierung des strahlungsemittierenden Halbleiterchips versehen.

Auf die Oberfläche des Trägerkörpers ist beispielsweise eine dielektrische Schicht, zum Beispiel aus Siliziumoxid, Titanoxid, Zirkonoxid oder Siliziumnitrid aufgebracht.

Der Linsenkörper besteht bei der Erfindung aus einem Glas, wobei unter einem Glas alle Arten von Gläsern mit beliebigen Zusätzen und insbesondere auch Glaskeramiken verstanden werden. Beispielsweise kann das Glas Blei enthalten. Vorzugsweise handelt es sich um ein niedrigschmelzendes Glas, um insbesondere den Herstellungsaufwand zu vermindern. Zum Beispiel handelt es sich bei dem Glas um ein Quarzglas, das sich insbesondere durch seine Transparenz im ultravioletten Spektralbereich auszeichnet.

Der Linsenkörper und der Trägerkörper umchließen die Vergußmasse vollständig, in die der strahlungsemittierende Halbleiterchip eingebettet ist, und verhindert so vorteilhaft das Eindringen von Feuchtigkeit. Die Form des Linsenkörpers ist im Rahmen der Erfindung frei wählbar und kann zur Optimierung der Lichtauskopplung an verschiedene Ausführungsformen von Lumineszenzdioden angepaßt werden.

Die Vergußmasse enthält bevorzugt Polymere, die möglichst wenig unter dem Einfluß ultravioletter Strahlung instabile Gruppen enthalten, insbesondere keine aromatischen Gruppen. Beispielsweise kann die Vergußmasse Polysiloxan, Polysilsesquioxane, Styrol, Fluorverbindungen und/oder Vinylchlorid enthalten. Eine geeignete Fluorverbindung ist beispielsweise Polytetrafluorethylen.

Vorzugsweise ist der Linsenkörper durch die Vergußmasse mit dem Trägerkörper verklebt. Die Vergußmasse sollte dazu vorteilhaft sowohl eine gute Haftung auf dem Linsenkörper aus Glas als auch auf dem Trägerkörper aus Silizium oder einer Keramik aufweisen.

Zur Kompensation der thermischen Ausdehnung der Vergußmasse, die durch die bei dem Betrieb der Lumineszenzdiode auftretende Erwärmung hervorgerufen wird, ist der Trägerkörper und/oder der Linsenkörper mit einer der Vergußmasse zugewandten Aussparung versehen. Im erkalteten Zustand der Lumineszenzdiode ist diese Aussparung nicht vollständig mit der Vergußmasse ausgefüllt, so daß diese sich bei Erwärmung in diese Aussparung ausdehnen kann. Eine derartige Aussparung kann beispielsweise in den Trägerkörper oder in den Linsenkörper geätzt oder gefräst sein.

Die Erfindung wird im folgenden anhand eines Ausführungsbeispiels im Zusammenhang mit den Figuren 1 bis 4 näher erläutert.

### Es zeigen

Figur 1 eine schematische Aufsicht auf eine Lumineszenzdiode gemäß einem Ausführungsbeispiel der Erfindung,
Figur 2 einen schematischen Querschnitt entlang der Linie A-A' des in Figur 1 dargestellten Ausführungsbeispiels,
Figur 3 einen schematische Querschnitt entlang der Linie B-B' des in Figur 1 dargestellten Ausführungsbeispiels und Figur 4 einen schematischen Querschnitt entlang der Linie C-C' des in Figur 1 dargestellten Ausführungsbeispiels.

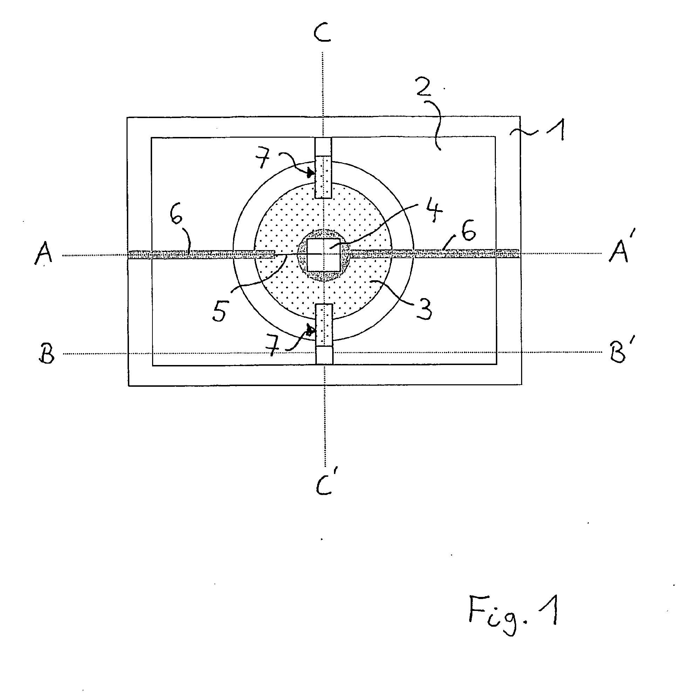

Gleiche oder gleichwirkende Elemente sind in den Figuren mit gleichen Bezugszeichen versehen. Das in den Figuren 1 bis 4 zum besseren Verständnis in verschiedenen Ansichten dargestellte Ausführungsbeispiel der Erfindung wird im folgenden zusammenhängend erläutert, ohne daß dabei jeweils auf eine der Figuren verwiesen wird.

Eine Lumineszenzdiode enthält einen strahlungsemittierenden Halbleiterchip 4, der in eine Vergußmasse 3 eingebettet ist, einen Trägerkörper 1 und einen Linsenkörper 2. Der Trägerkörper 1 besteht aus Silizium oder einer Keramik und der Linsenkörper 2 aus Glas. Insbesondere enthalten weder der Trägerkörper 1 noch der Linsenkörper 2 gegen UV-Strahlung empfindliche Polymere.

Vorzugsweise enthält die Vergußmasse 3 Polymere, die gegen ultraviolette Strahlung vergleichsweise unempfindlich sind, beispielsweise Polysiloxan, Polysilsesquioxane, Styrol, Fluorverbindungen und/oder Vinylchlorid. Als Fluorverbindung ist insbesondere Polytetrafluorethylen geeignet. Ein derartiges Gehäuse einer Lumineszenzdiode zeichnet sich durch eine weitgehende Unempfindlichkeit gegen ultraviolette Strahlung und außerdem durch eine durch die Form des Linsenkörpers optimierbare, effiziente Strahlungsauskopplung aus. Insbesondere für Halbleiterchips, die im ultravioletten Spektralbereich emittieren, und beispielsweise einen Nitridverbindungshalbleiter der dritten und/oder fünften Hauptgruppe aufweisen, insbesondere GaN, AlGaN, InGaN, AlInGaN, AlN oder InN, ist ein solches Gehäuse geeignet.

Zur elektrischen Kontaktierung des strahlungsemittierenden Halbleiterchips 4 sind auf dem-Trägerkörper elektrische Leiterbahnen 6 vorgesehen. Beispielsweise kann der Halbleiterchip 4 mit seiner Unterseite auf einer der elektrischen Leiterbahnen 6 befestigt sein, und an einer Oberseite über einen Bonddraht 5 mit einer weiteren Leiterbahn 6 verbunden sein. Die Leiterbahnen 6 sind unter dem Linsenkörper 2 hindurch bis in nicht vom Linsenkörper 2 bedeckte Außenbereiche des Trägerkörpers 1 geführt, und dienen dort zur elektrischen Kontaktierung der Lumineszenzdiode, beispielsweise durch Löten. Der Trägerkörper 1 ist bevorzugt mit einer dielektrischen Oberflächenbeschichtung, beispielsweise aus Siliziumoxid, Titanoxid, Zirkonoxid oder Siliziumnitrid versehen, und damit von der elektrischen Kontaktierung isoliert.

Die Vergußmasse 3 ist vollständig von dem Linsenkörper 2 und dem Trägerkörper 1 umschlossen. Insbesondere wird dadurch ein Eindringen von Feuchtigkeit in die Vergußmasse verhindert. Hierfür eignet sich besonders eine Vergußmasse 3, die sowohl auf dem Linsenkörper 2 als auch auf dem Trägerkörper 1 gut haftet, und so zugleich zum Verkleben des Trägerkörpers 1 mit dem Linsenkörper 2 dienen kann.

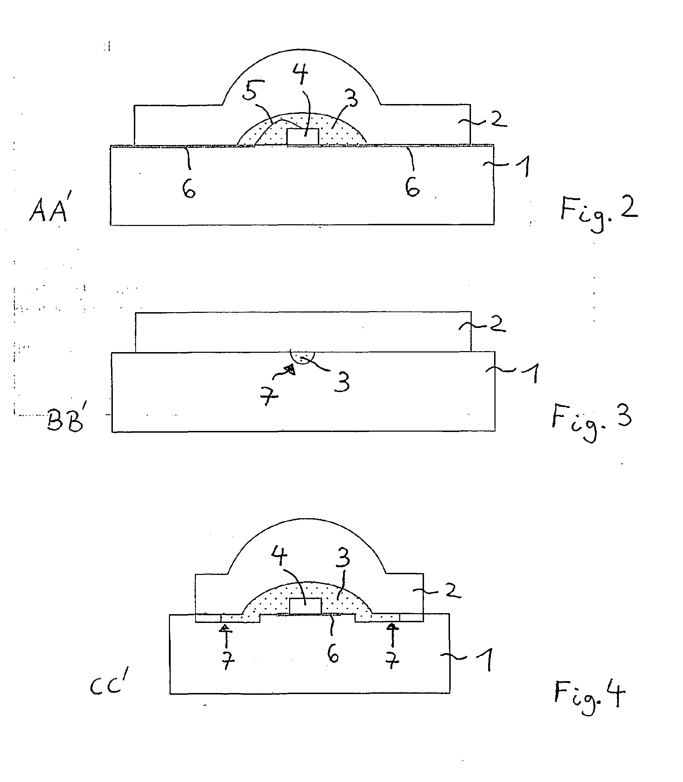

Bei einer Erwärmung der Lumineszenzdiode während des Betriebs besteht die Gefahr, daß sich die Vergußmasse 3 und der Trägerkörper 1 oder der Linsenkörper 2 unterschiedlich stark ausdehnen, wodurch mechanische Spannungen oder sogar eine Zerstörung der Lumineszenzdiode auftreten können. Um die thermische Ausdehnung der Vergußmasse 3 zu kompensieren, ist in dem Trägerkörper 1 eine Aussparung 7 vorgesehen, die im erkalteten Zustand der Lumineszenzdiode nicht vollständig mit der Vergußmasse 3 ausgefüllt ist, so daß sich die Vergußmasse bei Erwärmung in diese Aussparung 7 hinein ausdehnen kann. Diese Aussparung 7 zur Aufnahme der Vergußmasse im erwärmten Zustand kann beispielsweise durch Ätzen oder Fräsen des Trägerkörpers hergestellt sein. Die Aussparung 7 kann, wie beispielhaft in Figur 3 dargestellt, einen halbrunden Querschnitt aufweisen, wobei im Rahmen der Erfindung aber auch beliebige andere Querschnittsformen denkbar sind. Weiterhin kann die Aussparung 7 anstatt in dem Trägerkörper 1 auch in dem Linsenkörper 2 vorgesehen sein.

## Patentansprüche

1. Lumineszenzdiode mit einem in eine Vergußmasse (3) eingebetteten, auf einem Trägerkörper (1) befestigten strahlungsemittierenden Halbleiterchip (4), und einem Linsenkörper (2), wobei
der Trägerkörper (1) aus Silizium oder einer Keramik besteht und der Linsenkörper (2) aus einem Glas besteht, wobei
der Trägerkörper (1) und/oder der Linsenkörper (2) eine der Vergußmasse (3) zugewandte Aussparung zur Kompensation der thermischen Ausdehnung der Vergußmasse (3) aufweisen, **dadurch gekennzeichnet, daß** die Vergußmasse (3) vollständig von dem Linsenkörper (2) und dem Trägerkörper (1) umschlossen ist.

2. Lumineszenzdiode nach Anspruch 1,
**dadurch gekennzeichnet, daß**
die Keramik Aluminiumnitrid oder Aluminiumoxid enthält.

3. Lumineszenzdiode nach einem der vorhergehenden Ansprüche,
**dadurch gekennzeichnet, daß**
die Vergußmasse (3) Polysiloxan, Polysilsesquioxane, Styrol, Fluorverbindungen wie insbesondere Polytetrafluorethylen, und/oder Vinylchlorid enthält.

4. Lumineszenzdiode nach einem der vorhergehenden Ansprüche,
**dadurch gekennzeichnet, daß**
der Linsenkörper (2) mit dem Trägerkörper (1) durch die Vergußmasse (3) verklebt ist.

5. Lumineszenzdiode nach einem der vorhergehenden Ansprüche,
**dadurch gekennzeichnet, daß**
der Trägerkörper (1) mit Leiterbahnen (6) zur Kontaktierung der strahlungsemittierenden Halbleiterchips (4) versehen ist.

6. Lumineszenzdiode nach einem der vorhergehenden Ansprüche,
**dadurch gekennzeichnet, daß**
die dem Halbleiterchip (4) zugewandte Oberfläche des Trägerkörpers (1) zumindest teilweise mit einer isolierenden dielektrischen Beschichtung versehen ist.

7. Lumineszenzdiode nach einem der vorhergehenden Ansprüche,
**dadurch gekennzeichnet, daß**
der Halbleiterchip (4) Strahlung im blauen oder ultravioletten Spektralbereich emittiert.

8. Lumineszenzdiode nach einem der vorhergehenden Ansprüche,
**dadurch gekennzeichnet, daß**
der Halbleiterchip (4) einen Nitridverbindungshalbleiter enthält.

9. Lumineszenzdiode nach einem der vorhergehenden Ansprüche,
**dadurch gekennzeichnet, daß**
der Nitridverbindungshalbleiter eine Nitridverbindung von Elementen der dritten und/oder fünften Hauptgruppe, insbesondere GaN, AlGaN, InGaN, AlInGaN, AIN oder InN ist.

## Claims

1. Luminescence diode comprising a radiation-emitting semiconductor chip (4) embedded into a potting compound (3) and fixed on a carrier body (1), and a lens body (2), wherein
the carrier body (1) consists of silicon or a ceramic and the lens body (2) consists of a glass, wherein the carrier body (1) and/or the lens body (2) have/has a cutout facing the potting compound (3) and serving for compensating for the thermal expansion of the potting compound (3), **characterized in that** the potting compound (3) is completely enclosed by the lens body (2) and the carrier body (1).

2. Luminescence diode according to claim 1,
**characterized in that**
the ceramic contains aluminium nitride or aluminium oxide.

3. Luminescence diode according to either of the preceding claims,
**characterized in that**
the potting compound (3) contains polysiloxanes, polysilsesquioxanes, styrene, fluorine compounds such as, in particular, polytetrafluoroethylene, and/or vinyl chloride.

4. Luminescence diode according to any of the preceding claims,
**characterized in that**
the lens body (2) is adhesively bonded with the carrier body (1) by the potting compound (3).

5. Luminescence diode according to any of the preceding claims,
**characterized in that**
the carrier body (1) is provided with conductor tracks (6) for making contact with the radiation-emitting semiconductor chip (4).

6. Luminescence diode according to any of the preceding claims,
**characterized in that**
that surface of the carrier body (1) which faces the semiconductor chip (4) is at least partly provided with an insulating dielectric coating.

7. Luminescence diode according to any of the preceding claims,
**characterized in that**
the semiconductor chip (4) emits radiation in the blue or ultraviolet spectral range.

8. Luminescence diode according to any of the preceding claims,
**characterized in that**
the semiconductor chip (4) contains a nitride compound semiconductor.

9. Luminescence diode according to any of the preceding claims,
**characterized in that**
the nitride compound semiconductor is a nitride compound of elements of the third and/or fifth main group, in particular GaN, AlGaN, InGaN, AlInGaN, AIN or InN.

## Revendications

1. Diode électroluminescente comportant une puce à semi-conducteur (4) émettrice de rayonnement noyée dans une masse de scellement (3) et fixée à un corps de support (1), et un corps de lentille (2), dans lequel le corps de support (1) est constitué de silicium ou d'une céramique et le corps de lentille (2) est constitué d'un verre, dans lequel
le corps de support (1) et/ou le corps de lentille (2) présentent un évidemment faisant face à la masse de scellement (3) pour compenser la dilatation thermique de la masse de scellement (3), **caractérisée en ce que** la masse de scellement (3) est entièrement entourée par le corps de lentille (2) et le corps de support (1).

2. Diode électroluminescente selon la revendication 1, **caractérisée en ce que** la céramique contient du nitrure d'aluminium ou de l'oxyde d'aluminium.

3. Diode électroluminescente selon l'une quelconque des revendications précédentes, **caractérisée en ce que** la masse de scellement (3) contient du polysiloxane, du polysilsesquioxane, du styrène, des composés fluorés, notamment tels que le polytétrafluoréthylène et/ou le chlorure de vinyle.

4. Diode électroluminescente selon l'une quelconque des revendications précédentes, **caractérisée en ce que** le corps de lentille (2) est collé au corps de support (1) par l'intermédiaire de la masse de scellement (3).

5. Diode électroluminescente selon l'une quelconque des revendications précédentes, **caractérisée en ce que** le corps de support (1) est muni de pistes conductrices (6) pour établir un contact avec la puce semi-conductrice émettrice de rayonnement (4).

6. Diode électroluminescente selon l'une quelconque des revendications précédentes, **caractérisée en ce que** la surface du corps de support (1) faisant face à la puce semi-conductrice (4) est munie au moins en partie d'un revêtement diélectrique isolant.

7. Diode électroluminescente selon l'une quelconque des revendications précédentes, **caractérisée en ce que** la puce semi-conductrice (4) émet un rayonnement dans la région spectrale bleue ou ultraviolette.

8. Diode électroluminescente selon l'une quelconque des revendications précédentes, **caractérisée en ce que** la puce semi-conductrice (4) contient un semi-conducteur à base d'un composé de nitrure.

9. Diode électroluminescente selon l'une quelconque des revendications précédentes, **caractérisée en ce que** le semi-conducteur à base d'un composé de nitrure est un composé de nitrure d'éléments du troisième et/ou du cinquième groupe principal, notamment le GaN, l'AlGaN, l'InGaN, l'AlInGaN, l'AlN ou l'InN.
